(19) Europäisches Patentamt
European Patent Office
Office européen des brevets

(11) EP 2 713 414 A1

(12) # EUROPEAN PATENT APPLICATION

(43) Date of publication:
**02.04.2014 Bulletin 2014/14**

(21) Application number: **12186861.6**

(22) Date of filing: **01.10.2012**

(51) Int Cl.:
***H01L 51/00*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Solvay SA**
**1120 Brussels (BE)**

(72) Inventors:
- **Gaudin, Olivier P.M.**
  **B 1040 Brussels (BE)**
- **Caille, Jean-Raphael**
  **B 5000 Namur (BE)**
- **Maunoury, Jonathan**
  **B 1030 Brussels (BE)**
- **Orselli, Enrico**
  **B 1050 Brussels (BE)**

(74) Representative: **Langfinger, Klaus Dieter**
**Boehmert & Boehmert**
**Pettenkoferstrasse 20-22**
**80336 München (DE)**

(54) **Process for the manufacture of a multilayer structure**

(57) A process for the manufacture of a multilayer structure suitable for forming part of an organic electronic device having a cathode and an anode, comprising the subsequent deposition of at least two layers with an intermediate step to reduce the solubility of the deposited first layer before deposition of the second layer.

EP 2 713 414 A1

## Description

The present invention relates to a process for the manufacture of a multilayer structure suitable for forming part of an organic electronic device.

Today various organic electronic devices are under active study and development, in particular optoelectronic devices based on electroluminescence (EL) from organic materials.

In contrast to photoluminescence, i.e. the light emission from an active material as a consequence of optical absorption and relaxation by radiative decay of an excited state, electroluminescence (EL) is a non-thermal generation of light resulting from the application of an electric field to a substrate. In this latter case, excitation is accomplished by recombination of charge carriers of contrary signs (electrons and holes) injected into an organic semiconductor in the presence of an external circuit.

A simple prototype of an organic light-emitting diode (OLED), i.e. a single layer OLED, is typically composed of a thin film of an active organic material which is sandwiched between two electrodes, one of which needs to have a degree of transparency sufficient in order to observe light emission from the organic layer.

If an external voltage is applied to the two electrodes, charge carriers, i.e. holes at the anode and electrons at the cathode, are injected to the organic layer beyond a specific threshold voltage depending on the organic material applied. In the presence of an electric field, charge carriers move through the active layer and are non-radiatively discharged when they reach the oppositely charged electrode. However, if a hole and an electron encounter one another while drifting through the organic layer, excited singlet (anti-symmetric) and triplet (symmetric) states, so-called excitons, are formed. For every three triplet excitons that are formed by electrical excitation in an OLED, one anti-symmetric state (singlet) exciton is created. Light is thus generated in the organic material from the decay of molecular excited states (or excitons) according to a radiative recombination process known as either fluorescence for which spin symmetry is preserved, or phosphorescence when luminescence from both singlet and triplet excitons can be harvested.

High efficiency OLEDs based on small molecules usually comprise a multiplicity of different layers, each layer being optimized towards achieving the optimum efficiency of the overall device.

Typically such OLEDs comprise a multilayer structure comprising multiple layers serving different purposes. Devices generally referred to as p-i-n OLED comprise typically at least five layers: a p-doped transport layer (also referred to as hole transport layer or HTL), an usually undoped hole blocking layer (HBL), at least one emissive layer (EML), an usually undoped electron blocking layer (EBL) and a doped electron transport layer (ETL).

In order to achieve an optimum efficiency, the physical properties of each material for each individual layer of the stack (as e.g. carrier transport properties, HOMO and LUMO levels, triplet levels ) have to be selected properly depending on the functionality of the layer. As a result thereof, chemical composition and molecular structure of the materials usually differ from each other and the OLED stack of such a device is referred to as a heterojunction device.

Until today, small molecule (SM) based multilayer OLEDS have been prepared generally by vacuum deposition technologies whereby the layers are consecutively deposited on each other from the gas phase. In vacuum evaporation processes organic molecules are heated, evaporated and then condensed onto the substrate. A mask has to be used to pattern an organic layer for the actual pixels which makes the method relatively inefficient and expensive as most of the evaporated material is wasted (it does not end up on the substrate at the targeted position).

In accordance with the organic vapour jet deposition method, the organic materials are transported to the substrate with a carrier gas, which makes this process more efficient than the vacuum evaporation process, but there is still improvement in efficiency and economics desirable.

Multilayer systems of the heterojunction type are difficult to obtain when the materials are processed from solution because deposition of one layer on the preceding layer suffers from various interactions and interferences which deteriorate device performance. Technologies like cross-linking of a layer prior to deposition of the next layer or the so called orthogonal solvent technique, in which solvents are used for deposition of the material of a layer which do not interact or interfere with the previous layer onto which it is deposited, have been developed.

For OLEDs manufactured by vacuum technologies (deposition from the gas phase) so called homojunction-type OLEDs have been described in the literature. Such devices are characterized by the fact that the number of different matrix materials used for the different layers is lower than the number of layers, i.e. at least two of the layers have the same matrix material. In an ideal homojunction device, all the matrix materials are identical or at least very similar in molecular properties and structure.

US patent 7,911,129 relates to an organic p-i-n type light emitting diode with a stack of layers between two electrodes wherein the overall number of matrix materials for the layers is smaller than the number of layers of the stack. The different layers are deposited by vacuum technologies, i.e. from the gas phase.

Cai et al., Organic Electronics 12, 843 (2011) describe high-efficiency phosphorescent homojunction organic light emitting diodes comprising bipolar host materials based on carbazolyl phenyl pyridines or pyrimidines. The consecutive layers of the stack are deposited from the gas phase.

Harada et al. Phys. Rev. Lett., 94, 036601 (2005) describes organic homojunction diodes with a high built in

potential where the various layers are deposited from the gas phase.

Harada et al., Phys. Review 77, 195212 (2008) report on pentacene homojunctions and their electron and hole transport properties. The difficulties in the realization of organic homojunctions are described and are seen in the establishing of an efficient charge transfer between the dopant used and the matrix. p-and n-type conductivity has to be established in the same matrix material. The process used for manufacturing of the devices is a vapour deposition process.

Zuniga et al, Chem. Mater. 2011, 23, 658-681 discuss approaches to solution processed multilayer organic light emitting diodes based on cross-linking. No homojunction type devices are reported.

OLED devices based on polymeric molecules (sometimes also referred to as PLED) have also been described in the literature. As these high molecular weight molecules are difficult if not impossible to vaporize, solution technologies have been described for their manufacture.

Leung et al., Proc. of SPIE, Vol. 6828, 68280D (2007) report on experiments with colour tunable vinyl copolymers for OLED applications. According to the abstract, OLEDs based on the investigated polymers have been prepared by spin coating from a solution of the copolymers in trichloromethane.

Ho et al, Appl. Phys. Lett. 85, 4576 (2004) describe conjugated polymer homojunction devices with efficient white light emission which are prepared by solution processing.

There still exists a need for an economical process for the manufacture of multilayer structures suitable for forming part of an organic electronic device, in particular for forming part of high performance OLEDs avoiding at least partly the disadvantages of the prior art described above.

Accordingly it was an object of the present invention to provide a process for the manufacture of multilayer structures suitable for forming part of an organic electronic device.

This object has been achieved with a process as claimed in claim 1.

Preferred embodiments of the present invention are set forth in the dependent claims and the detailed description hereinafter.

The present invention relates to a process for the manufacture of a multilayer structure suitable for forming part of an organic electronic device having a cathode and an anode, comprising the steps of

a. depositing a first layer L1 of the multilayer structure onto a substrate out of a liquid composition C1 comprising a solvent system S1 which solvent system S1 contains at least one organic molecule M1 having a molecular weight of at most 1,000 Dalton, wherein the substrate is a previously deposited layer L0 of the multilayer structure or is an element suitable for forming the cathode or the anode of the organic electronic device,

b. thereafter chemically modifying the first layer L1 to reduce its solubility, as measured at room temperature (23°C) and atmospheric pressure (101.325 kPa), in a solvent system S2 which is identical to or different from solvent system S1, by at least 50 %, based on the solubility of the first layer L1 in the solvent system S2 before modification and

c. thereafter depositing a second layer L2 of the multilayer structure onto the first layer L1 out of a liquid composition C2 comprising the solvent system S2, which solvent system comprises at least one organic molecule M2 having a molecular weight of at most 1,000 Dalton,

wherein

the organic molecule M1 contains $n^1$ polymerizable units G1 with $n^1$ being an integer of from 1 to 5,

the organic molecule M2 is identical to M1 or differs from M1 only in that in the organic molecule M2 1 to $n^1$ polymerizable units G1 have been replaced by polymerizable or non-polymerizable units G2 which differ from G1, and

wherein the HOMO and LUMO levels of the organic molecules M1 are the same as, or differ by at most 0.2 eV from, respectively, the HOMO and LUMO levels of the organic molecules M2. The HOMO level of the organic molecules used in the process of the present invention are determined by cyclic voltammetry in solution as follows.

The HOMO and LUMO levels of the organic molecules used in the process of the present invention are determined from cyclic voltammetry measurements in solution.

These measurements are performed at room temperature, under inert atmosphere, with a conventional three-electrode configuration, the solution being outgassed before use with a stream of Argon for 5-10 min. The three-electrode cell may consist e.g of a glassy carbon disk as working electrode, a Pt wire or a Pt rod as a counter electrode and a Pt wire or a carbon rod as pseudo-reference electrode. Ferrocene is used as an internal reference. Other cell configuration may also be used. The solvents used for the determination of the HOMO and LUMO levels are respectively anhydrous dichloromethane and anhydrous tetrahydrofuran, the supporting electrolyte is 0.1 M tetrabutylammonium hexafluorophosphate and the host concentrations are 2 - 0.5 millimolar. The scan rate is fixed to 100 mv/s.

The HOMO levels ($E_{HOMO}$) of the organic molecules used in the process of the present invention are calculated from the measured half wave potential of their first oxidation wave ($E_{1\ ox\ 1/2}$) using the following equation:

$$E_{HOMO} - (-4.8) = -[E_{1\ ox\ 1/2} - E_{ox\ 1/2}(Fc/Fc^+)]$$

wherein the ferrocene HOMO level value has been taken equal to -4.8 eV below the vacuum level according to Pommerehene et al. Adv. Mater. 7(6), 551-554 (1995) and wherein $E_{ox\ 1/2}(Fc/Fc^+)$ correspond to the measured half wave potential of the ferrocene oxidation wave. For irreversible systems, $E_{pa\ 1}$ peak potential value of the first oxidation wave is used instead of the half wave potential $E_{1ox\ 1/2}$.

The LUMO levels ($E_{HOMO}$) of the organic molecules used in the process of the present invention are calculated from the measured half wave potential of their first reduction wave ($E_{1ox\ 1/2}$) using the following equation:

$$E_{LUMO} - (-4.8) = -[E_{1\ red\ 1/2} - E_{ox\ 1/2}(Fc/Fc^+)]$$

wherein the ferrocene HOMO level value has been taken equal to -4.8 eV below the vacuum level according to Pommerehene et al. Adv. Mater. 7(6), 551-554 (1995) and wherein $E_{ox\ 1/2}(Fc/Fc^+)$ correspond to the measured half wave potential of the ferrocene oxidation wave. For irreversible systems, $E_{pc\ 1}$ peak potential value of the first reduction wave is used instead of the half wave potential $E_{1\ red\ ½}$.

If no reduction wave is observed in tetrahydrofuran, the LUMO level is calculated from the HOMO level deduced from cyclic voltammetry as hereabove and from the optical energy bandgap $E_{opt\ g}$ measured from the wavelength of the absorption edge $\lambda_{abs.\ edge}$ using the following equations:

$$E_{opt\ g}\ (eV) = 1240/\lambda_{abs.\ edge}\ (nm); \quad E_{LUMO}\ (eV) = E_{HOMO}\ (eV) + E_{opt\ g}\ (eV)$$

The values of the HOMO and LUMO levels of the organic molecules M1 and M2 to be compared must each be determined using the same procedure for each molecule.

The organic molecules M1 and M2 (which may be the same or different) used in the process in accordance with the present invention have a molecular weight of at most 1000 Dalton and more preferably of at most 700 Dalton. Even more preferably the molecular weight of organic molecules M1 and M2 is at most 600 Dalton.

The concentration of the organic molecules M1 and M2 in the solvent systems S1 and S2 (which may be the same or different) is not particularly critical. In many cases compounds M1 and M2 will be present in a concentration in the range of from 0.05 to 20, preferably from 0.1 to 10 and even more preferably of from 0.2 to 5 wt%, based on the combined weight of solvent system and organic molecule. The maximum concentration of the organic molecule in the solvent system is often defined by the solubility of the organic molecule in the solvent system; it is generally preferred to use the organic molecule M1 and M2 in a concentration not exceeding the solubility in the respective solvent system to avoid having part of the organic molecule as solid particles in the solvent system as these solid particles may detrimentally influence the processibility through solvent based processing techniques.

The organic molecule M1 comprises from 1 to 5, preferably from 1 to 3 and particularly preferably 2 or 3 polymerizable units G1.

The term polymerizable unit as used in the context of the present invention denotes a group which is capable of being polymerized by heat, irradiation or any other suitable method described in the art for polymerization processes. The term includes precursor groups which, e.g. by hydrolysis or other known methods can be converted to a polymerizable group.

An example for such precursor groups are halosilanes which upon hydrolysis yield siloxanes, which are polymerizable.

In accordance with a first preferred embodiment of the process of the present invention, the polymerizable units G1 are represented by general formula (1)

$$-(Z^1)_a - (Ph)_b - O_c - (C(=O))_d - O_e - A^1 \qquad (1)$$

wherein $Z^1$ may be the same or different at each occurrence, and is selected from compounds of formulae (2) to (4)

$$C(R^1R^2)-(C(R^3R^4))_m \qquad (2)$$

(3) 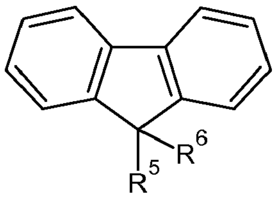 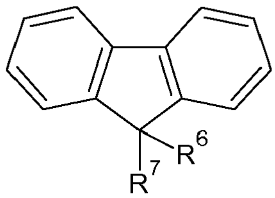 (4)

wherein the spacer $Z^1$ provides two bonding sites and

$R^1$ and $R^2$, independent of one another, each represent hydrogen, halogen, a $C_1$-$C_8$ alkyl group or an aryl group of from 5 to 30 carbon atoms,

$R^3$ and $R^4$, independent of one another, are hydrogen, a $C_1$ to $C_8$ alkyl group or an aryl group of from 5 to 30 carbon atoms and m is an integer of from 0 to 20,

$R^5$ represents hydrogen, $C_1$ to $C_8$-alkyl, or $C_5$ to $C_{30}$ aryl, and

$R^6$ and $R^7$, independently of one another, represent $C_1$-$C_8$ alkylene or $C_5$ to $C_{30}$ arylene and

a to e, independently of one another are 0 or 1.

A preferred group of spacers $Z^1$ are $C_1$-$C_8$ alkylene groups, which may be partially or fully halogenated. Representative preferred examples are $C_1$-$C_6$ alkylene groups, e.g. methylene, ethylene, propylene, butylene, pentylene or hexylene or the partly or fully halogenated equivalents thereof.

$A^1$ in polymerizable unit G1 comprises an unsaturation which, in step b of the process in accordance with the present invention, provides the reactivity to reduce the solubility of layer L1 before deposition of the layer L2.

In accordance with a first embodiment, organic molecule M1 via the unsaturation in $A^1$ can be polymerized to obtain higher molecular weight products, which may impart a significantly reduced solubility of layer L1 in solvent system S2 compared to the solubility of layer L1 in this solvent system prior to the polymerization. If the solubility reduction is at least 50%, no additional steps or additional measures are necessary.

In case that the reduction of solubility is not sufficient through polymerization alone, organic molecules M3 may be used in the liquid compositions. Details will be described hereinafter.

In accordance with a preferred embodiment as outlined above, organic molecule M1 contains more than one polymerizable unit G1 which in case of polymerization will lead to crosslinking. In general, crosslinked products have a lower solubility in solvent systems than uncrosslinked products, i.e. it may be expected that the reduction in solubility which can be achieved when more than one polymerizable unit G1 is present, is higher than in the case of mere polymerization with only one polymerizable unit G1. This is the reason why organic molecules M1 with more than one, especially preferably 2 or 3 and particularly preferably 2 polymerizable units G1 can be advantageously used in the process in accordance with the present invention.

$A^1$ is selected from the group consisting of $C_2$-$C_{20}$ alkenyl groups, $C_2$-$C_{20}$ halogenated alkenyl groups, $C_4$-$C_{20}$ alkadienyl groups, halogenated $C_4$-$C_{20}$ alkadienyl groups, $C_4$-$C_{20}$ cycloalkenyl groups or $C_4$-$C_{20}$ alkylene bridged cycloalkenyl groups. Representative examples are ethenyl, propenyl, butenyl, cyclobutenyl, cyclohexenyl, butadienyl, hexadienyl, cyclohexadienyl or alkylene bridged derivatives of these groups comprising two respective groups bridged by an alkylene group.

In accordance with a preferred embodiment a is 1 and in accordance with a further preferred embodiment at least one of b and c is 0.

In accordance with another preferred embodiment of the process of the present invention, the polymerizable unit $A^1$ is selected from vinyl ethers, halogenated vinyl ethers, siloxanes, oxetanes, cinnamates, chalcones, acrylates, methacrylates and styryl groups.

These polymerizable units may be generally represented by the following formulae

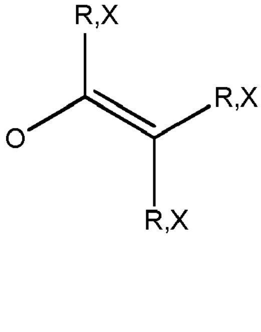 vinyl ethers, halogenated vinyl ethers

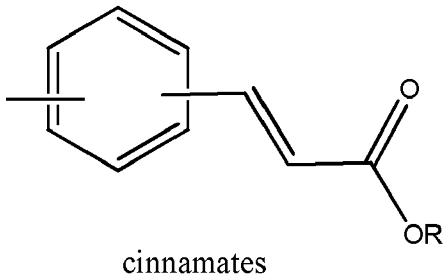

cinnamates

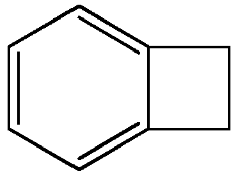

benzocyclobutanes

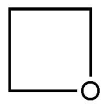

oxetanes

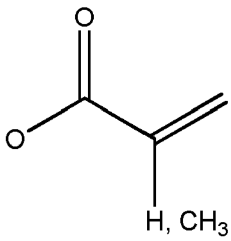

acrylates, methacrylates

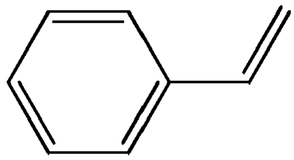

styryl

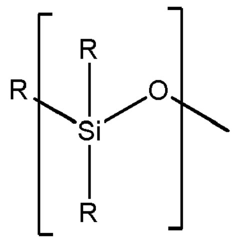

siloxanes

wherein R in the above structures stands for an alkyl or an alkylene group having from 1 to 20 carbon atoms.

Organic molecule M2 may be the same as M1 or differ from M1 only in the fact that one or more of the polymerizable units G1 in organic molecule M1 are replaced by polymerizable or non-polymerizable units G2 of formula (5)

$$-(Z^2)_{a'} - (Ph)_{b'} - O_{c'} - (C(=O))_{d'} - O_{e'} - A^2 \qquad (5)$$

wherein $A^2$ is chosen from hydrogen, halogen, $C_1$-$C_{20}$ alkyl groups, halogenated $C_1$-$C_{20}$ alkyl groups, $C_2$-$C_{20}$ alkenyl groups, $C_2$-$C_{20}$ halogenated alkenyl groups, $C_4$-$C_{20}$ alkadienyl groups, halogenated $C_4$-$C_{20}$ alkadienyl groups, $C_4$-$C_{20}$ cycloalkenyl groups or $C_4$-$C_{20}$ alkylene bridged cycloalkenyl groups, Ph is o-, m- or p-phenylene and $Z^2$ may be selected from the group of compounds defined before for $Z^1$ and a' to e', independent of one another, are 0 or 1.

M2 may differ from M1. In accordance with a preferred embodiment M1 and M2 are identical.

M2 as explained above may not comprise a polymerizable unit at all, it may comprise the same polymerizable units as M1 or it may comprise different polymerizable units than M1.

If M2 comprises different polymerizable units G2 than are present in M1, the G2 units may also be selected from the groups as described hereinbefore for G1.

The organic molecules M1 and M2 may be selected from a wide variety of compounds and the skilled person will make the appropriate selection for his intended purpose.

Ambipolar and cross-linkable compounds which have a sufficient solubility in the solvent systems used are generally suitable and respective compounds are known to the skilled person, who will select the appropriate compounds based on his knowledge and in accordance with the needs of the specific application.

A first group of preferred organic molecules which may be advantageously used in the process in accordance with the present invention are arylamine compounds comprising an arylamine core and at least one polymerizable group attached to one ring of the arylamine core

These arylamine compounds comprise an arylamine core. When used herein, the term arylamine core generally denotes a structural element where aryl groups are attached to one or more nitrogen atoms.

Generally, an arylamine core can be depicted as $NAr^1Ar^2Ar^3$ wherein $Ar^1$, $Ar^2$ and $Ar^3$, which may be the same or different, represent a substituted or unsubstituted $C_5$ to $C_{30}$ aryl- or a substituted or unsubstituted $C_2$ to $C_{30}$ hetereoaryl group. Preferred examples of aryl groups are phenyl, naphthyl and anthracenyl, especially phenyl or naphthyl. Preferred heteroaryl groups are five or six membered heteroaryl compounds comprising at least one heteroatom, preferably selected from O, N and S, particularly preferred the heteroaryl ring contains at least one nitrogen atom.

A first preferred class of arylamine compounds in accordance with the present invention is represented by compounds of general formula (6)

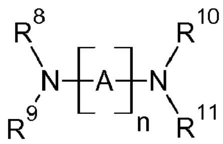

(6)

wherein at least one of A and $R^8$ to $R^{11}$ carries an addition-polymerizable group attached through a spacer of general formula (1) wherein A can have the same meaning as $Ar^1$ defined above; preferably A is selected from the group consisting of substituted or unsubstituted 5 to 7 membered aryl or heteroaryl rings, n is1, 2 or 3 and $R^8$ to $R^{11}$, independent of one another, are unsubstituted or substituted $C_5$ to $C_{30}$ aryl or $C_2$ to $C_{30}$ heteroaryl rings as defined before for $Ar^1$.

In accordance with another preferred embodiment, the compounds of the present invention of formula (6) comprise a substituted or unsubstituted phenyl or naphthyl group.

The addition polymerizable group preferably comprises at least one unsaturated bond which may be polymerized by addition polymerization.

The polymerizable unit is preferably selected from the group consisting of

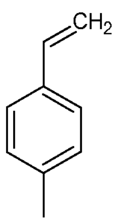
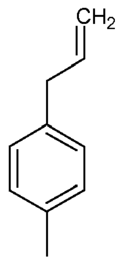
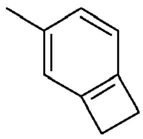
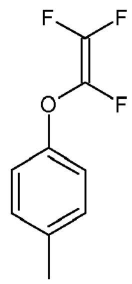
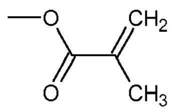
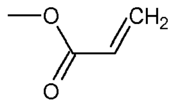

Vinyl groups are generally preferred as polymerizable unit G1 or G2, particularly vinylphenyl (also commonly referred to as styryl or vinylphenyl).

The following specific examples of arylamine compounds (formulae I to XLIV), individually, can be advantageously used in the present invention, process of the present invention, compounds XVII to XLIV being especially preferred.

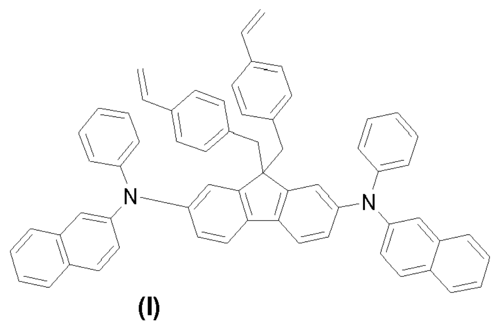

**(I)**

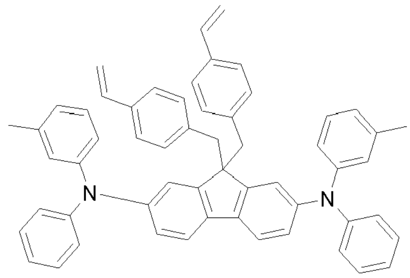

**(II)**

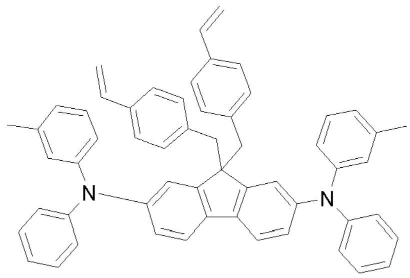

(III)

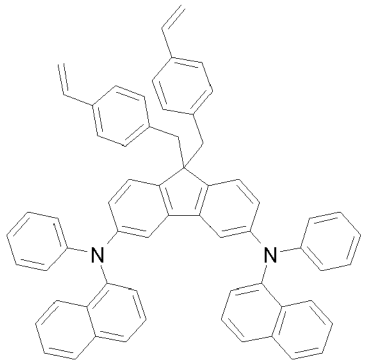

(IV)

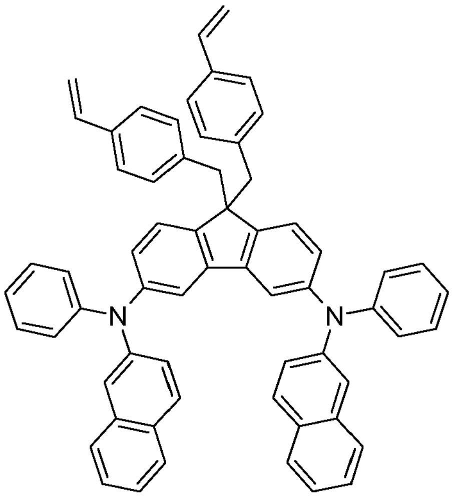

(V)

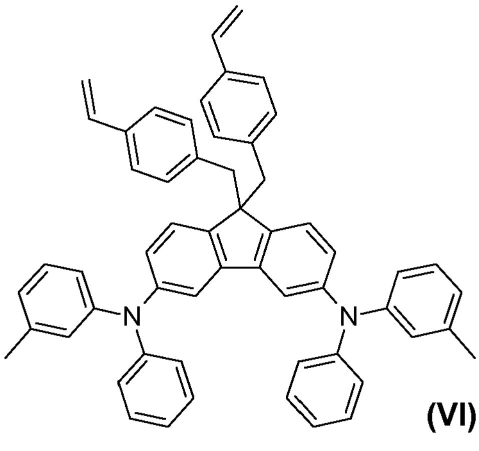

(VI)

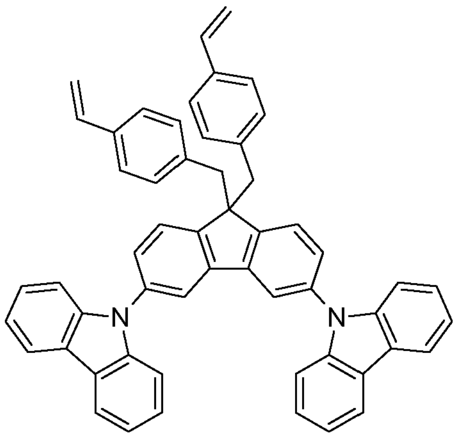

(VII)

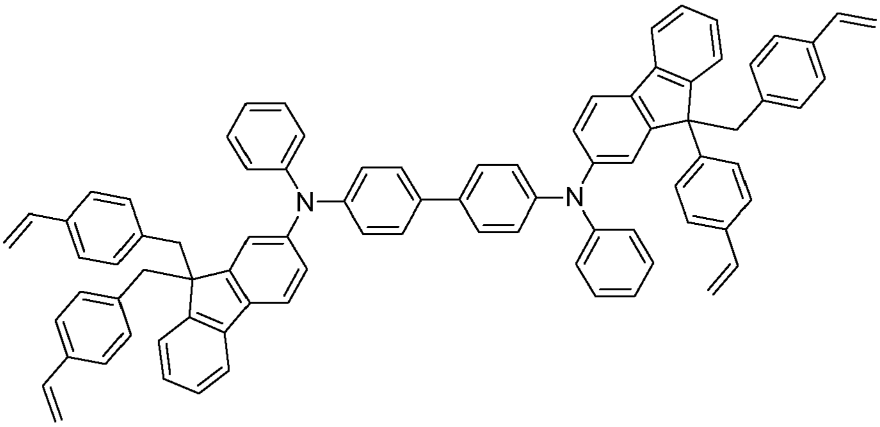

(VIII)

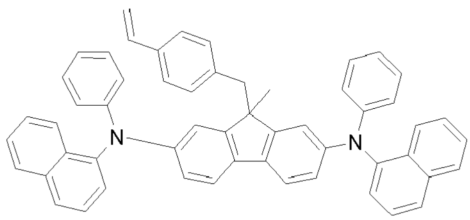

(IX)

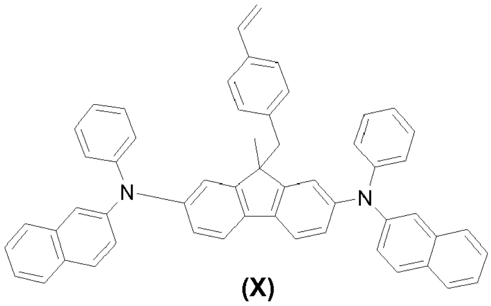

(X)

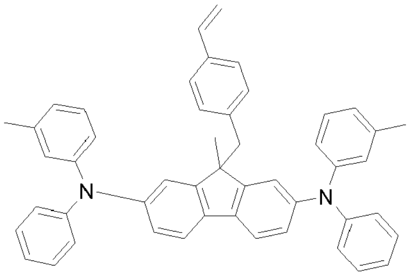

(XI)

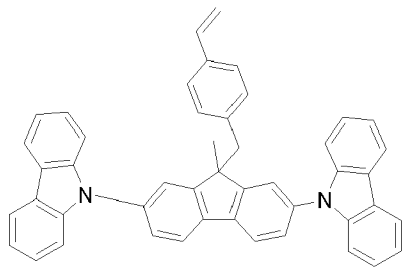

(XII)

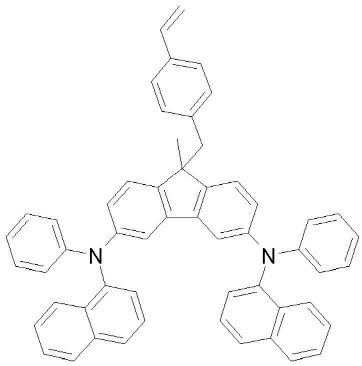

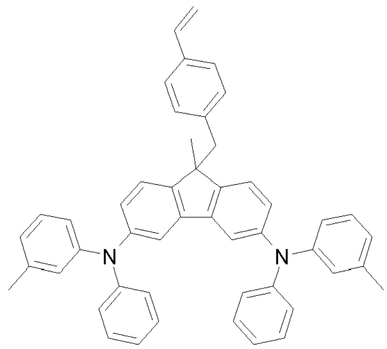

**(XIII)**

**(XIV)**

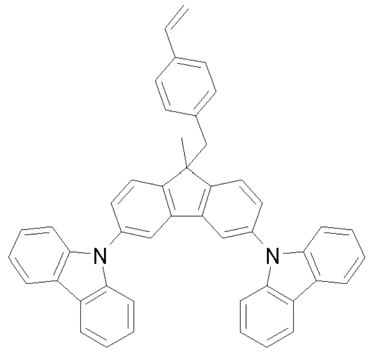

**(XV)**

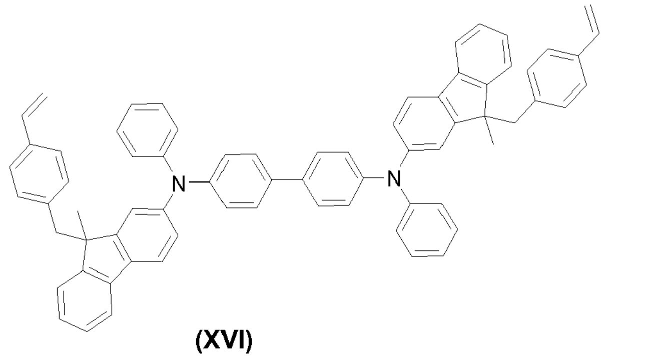

**(XVI)**

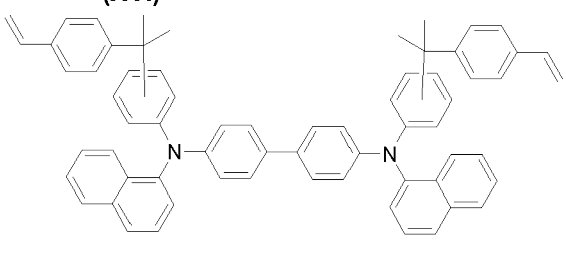

**(XVII)**

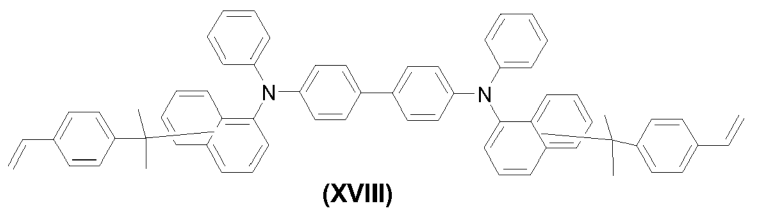

**(XVIII)**

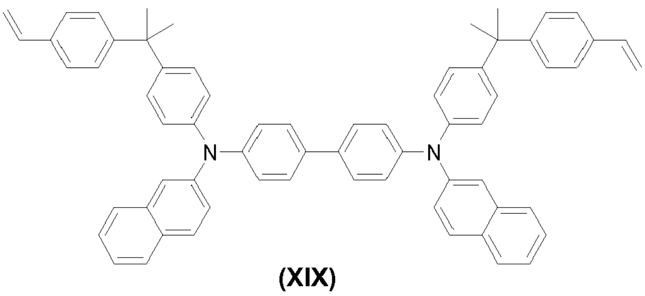

(XIX)

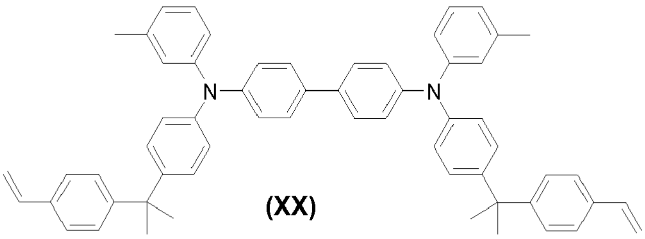

(XX)

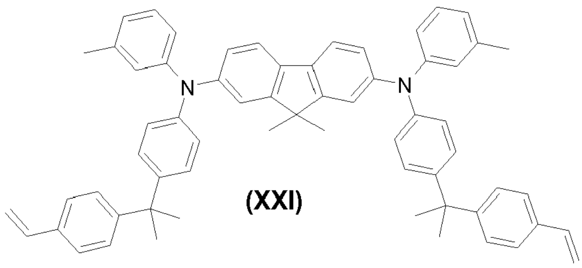

(XXI)

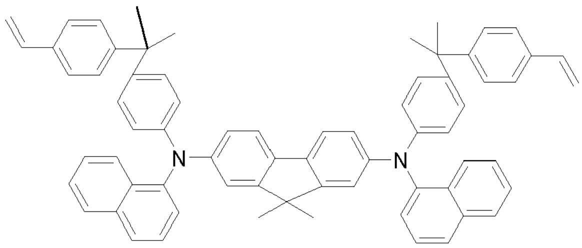

(XXII)

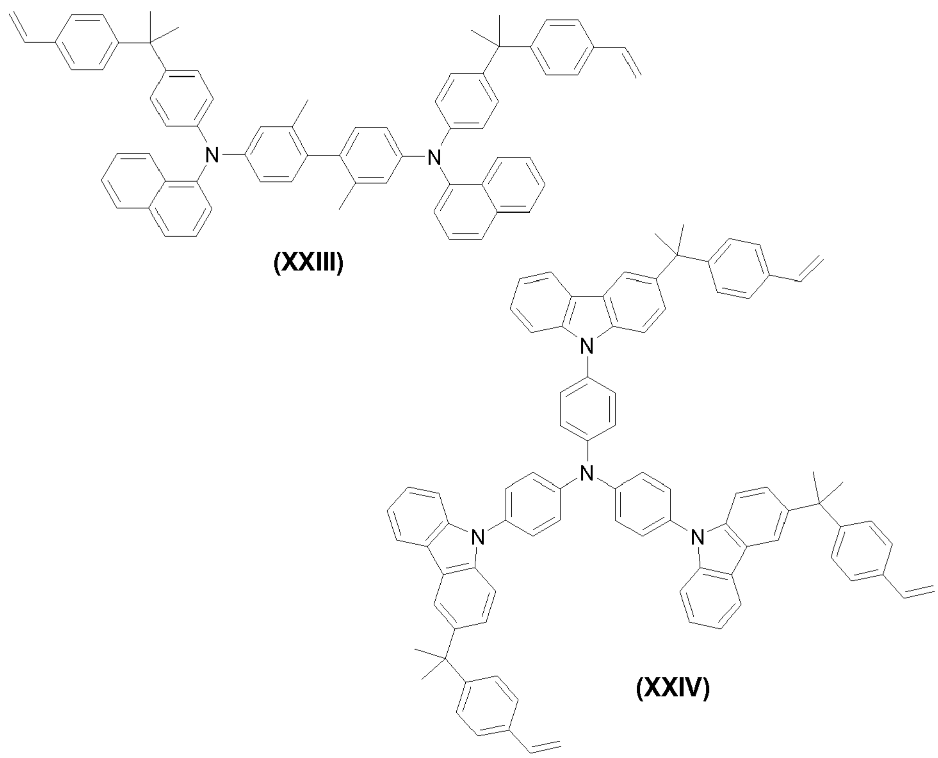

(XXIII)

(XXIV)

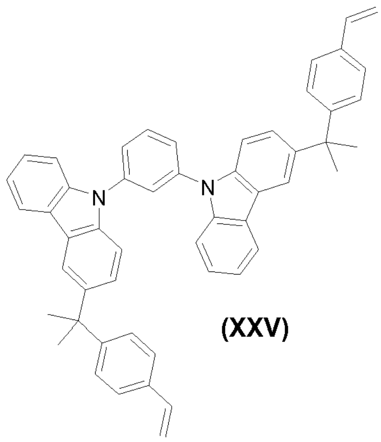

(XXV)

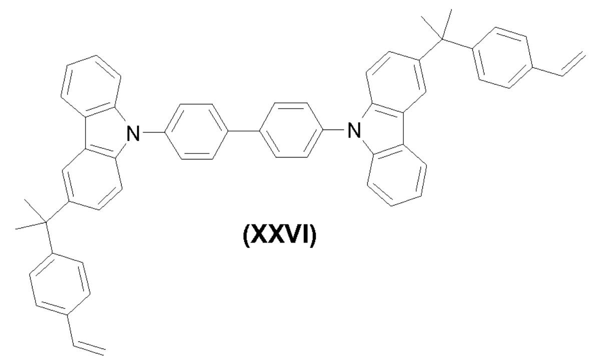

(XXVI)

(XXVII)

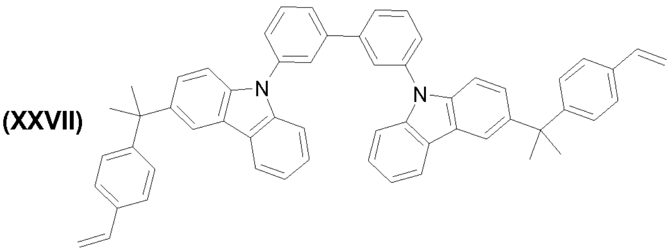

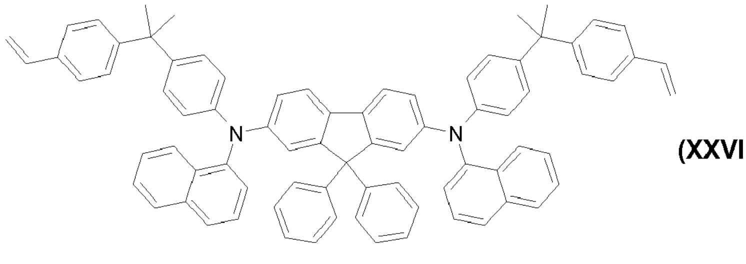

(XXVIII)

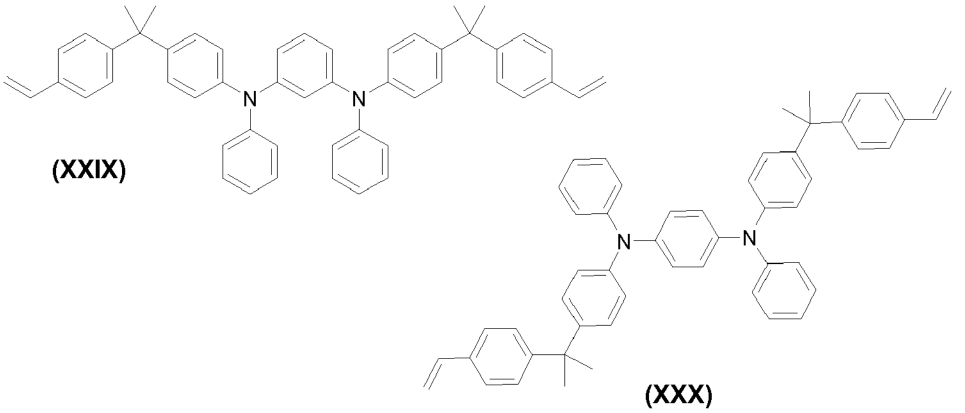

(XXIX)

(XXX)

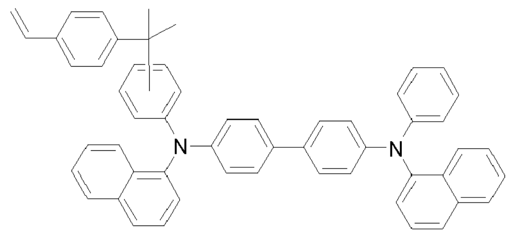

(XXXI)

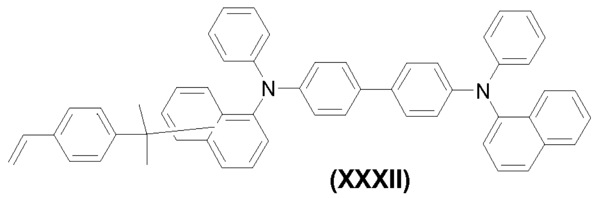

(XXXII)

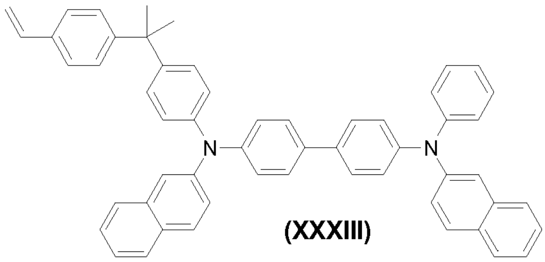

(XXXIII)

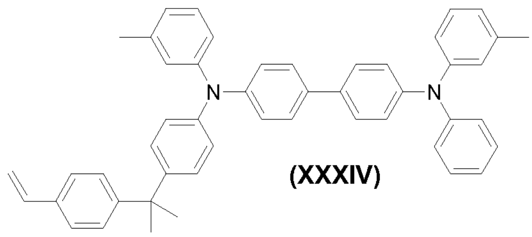

(XXXIV)

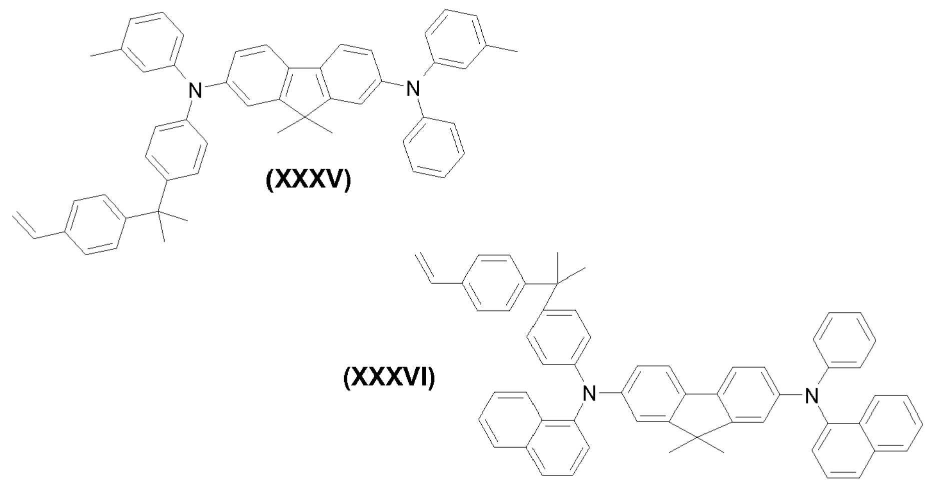

(XXXV)

(XXXVI)

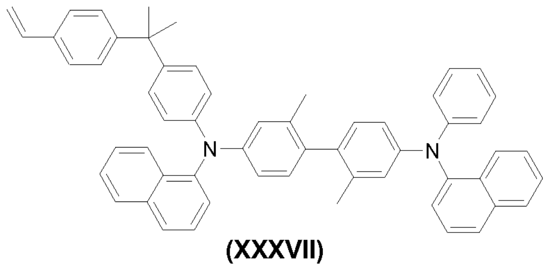

(XXXVII)

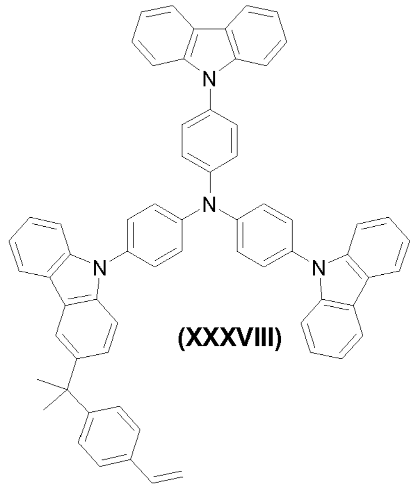

(XXXVIII)

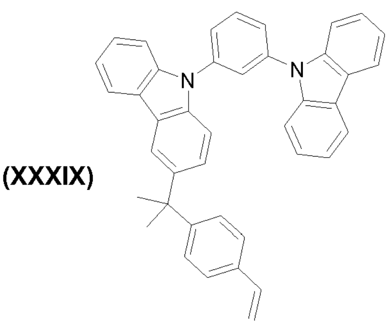

(XXXIX)

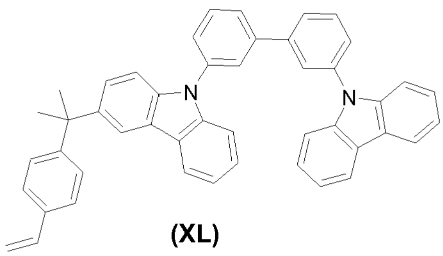

(XL)

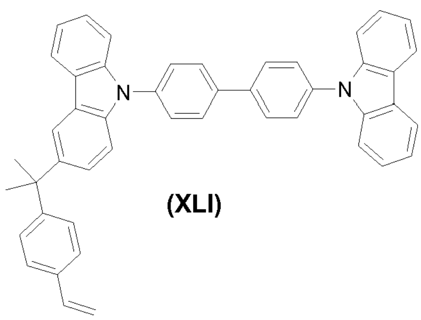

(XLI)

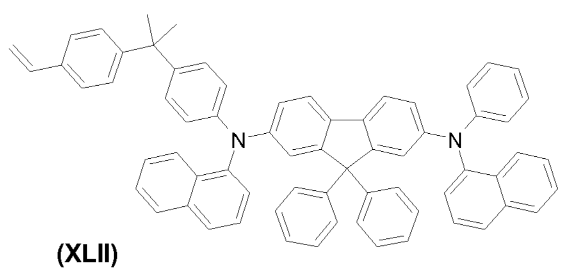

(XLII)

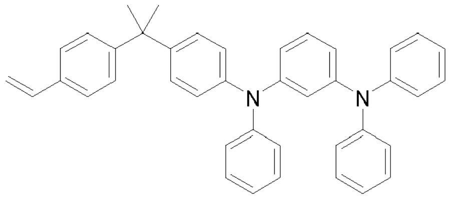

(XLIII)

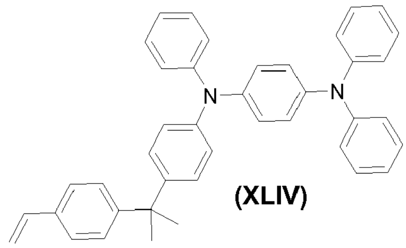

(XLIV)

Other suitable organic molecules which may be used as M1 and/or M2 in the process of the present invention, have been described in the literature, i.e. in Zuniga et. al, Chem. Mater. 2011, 23, 658 et seq. to which reference is made herewith.

As a general rule, any compound known from the prior art which has been described for use in multilayer structures of organic electronic devices may be used, provided modification with a polymerizable group in case of organic molecule M1 is possible.

The skilled person will select the appropriate organic molecules M1 and M2 depending on the purpose of the layer for which the molecules are used based on his professional skills and knowledge.

In the first step of the process in accordance with the present invention, a first layer L1 of the desired multilayer structure is deposited onto a substrate out of a liquid composition C1 comprising a solvent system S1 which solvent system S1 comprises the organic material M1.

The substrate may be a previously deposited layer L0 or it may be an element suitable for forming the anode or cathode of the organic electronic device comprising the multilayer structure.

Suitable deposition methods are known to the skilled person and described in the literature, to which reference is made herewith for details. The skilled person will use his professional knowledge and select the solution based deposition method suited best for the specific situation.

Known methods for depositing a material out of a liquid composition are spin coating, spray coating and blade coating to mention only three representative examples.

In step b of the process in accordance with the present invention, the solubility, measured at 23°C and atmospheric pressure (101.325 kPa),of the layer L1 deposited in step a in the solvent system S2 used for depositing the second layer L2 is reduced by at least 50 %, preferably by at least 70 % and even more preferably by at least 90 %, compared to the solubility of the layer L1 in solvent system S2 before modification.

The solvent systems S1 and S2 may be the same or different and preferably are the same as this facilitates the process due to the avoidance of intermediate cleaning or solvent change steps or the like if a change of solvent compositions takes place.

The solvent compositions comprise one or more solvents which are selected to achieve a sufficient solubility of the organic molecules M1 and M2 in the respective solvent systems as this is advantageous for forming a homogenous thin layer.

Accordingly, the solvent or solvents in the solvent composition will be selected depending on the chemical structure and properties of organic molecules M1 and M2 selected for the specific project.

Generally, organic solvents will be used in the solvent composition. Although halogenated solvents like fluorinated hydrocarbons are in principle suitable in the process of the present invention, it is preferred to use solvents that are essentially free or entirely free of halogen atoms for safety and environmental reasons. Just by way of example, liquid alkanes, cycloalkanes, aldehydes, ketones, esters, ether or aromatic solvents may be mentioned. In certain deposition methods it may be preferable to use solvent mixtures to adjust the properties of the solvent system to achieve a homogenous thin layer in the deposition process. In this regard it has been shown to be advantageous in certain cases to use solvent mixtures comprising solvents with different boiling temperatures which on one hand provide smooth layers and on the other hand have an evaporation behaviour avoiding premature drying of the solvent composition during deposition which might be detrimental for the efficiency of the multilayer structure. Just by way of example, it may be mentioned here to use solvent combinations comprising a solvent with a boiling point at room temperature of at most 130°C with a solvent having a boiling point above that limit and preferably having a boiling point of at least 150°C, particularly preferably of at least 180°C. All boiling points refer to the boiling points at atmospheric pressure.

The solvent compositions, in addition to one or more solvents and the organic molecules may also contain further additives and processing aids commonly used in such compositions in solution based processes. These are commercially available and described in the literature and thus no further details are necessary here.

Zuniga et al., Chem. Mater. 2011, 23, 658 describe the conditions under which the polymerizable units shown above may be polymerized and/or cross-linked to achieve the reduction in solubility.

For the purpose of this invention cross-linking would be understood as a process whereby the formation of new chemical bonds leads to insolubilization of an organic layer by forming bonds between polymer or oligomer chains.

The formation of siloxanes with a three dimensional crosslinked network from the hydrolysis of halo- or alkoxysilanes is widely used in materials science. The process can lead to effective cross-linking and the resulting bonds are strong and stable. The hydrolysis step involves generally the exposure of the layer to moisture followed by a curing step at elevated temperature (generally 120°C or above). However, in certain cases the presence of moisture in the system is undesirable as it may be detrimental to the lifetime of the organic electronic device comprising the multilayer structure obtained in accordance with the process of the present invention. The skilled person will decide whether or not siloxanes and their crosslinking using moisture is acceptable or not in his specific situation.

Styryl groups usually require temperatures of 150°C or above to achieve the desired cross-linking and vinyl ethers and benzocyclobutenes often require even higher temperatures exceeding in many cases 200°C. Treatment of the layer at such elevated temperatures for several hours may be detrimental to the stability and the properties of the layer and thus styryl groups, offering a reasonable compromise of cross-linking temperature and time needed, may be advantageously used in a number of cases.

The time needed to achieve the desired decrease of solubility may range from a few minutes to several hours and depends on the structure of the respective organic molecule. Typically, reaction times in the range of from 5 minutes to 12 hours, preferably of from 15 minutes to 6 hours at the temperature needed for the respective polymerizable group are appropriate. Thus, e.g. for styryl-type polymerizable group reaction times of from 15 minutes to 6 hours at temperatures in the range of from 120 to 200°C, preferably of from 130 to 180°C have proved to yield the desired results.

UV-initiated cross-linking can be used for the radical polymerization of acrylates and the cationic polymerization of oxetanes. The radiation wavelength and intensity will be selected by the skilled person dependending on the actual organic molecules used.

The dimerization and crosslinking of cinnamates and chalcones in most cases occur by direct photooxidation of the polymerizable groups.

Photochemical processes offer the potential to avoid the high temperatures associated with thermal polymerization, but e.g. in the case of oxetane polymerization a heating step is also sometimes found to be useful to achieve the desired degree of reaction.

The oxetane and cinnamate/chalcone approaches can be advantageous because these groups are inert under radical polymerization conditions and thus can be readily incorporated as side chains into main chain acrylate or styrene polymers.

In step c of the process in accordance with the present invention, a second layer L2 of the multilayer structure is deposited onto the first layer out of a liquid composition C2 comprising a solvents system S2 which solvent system comprises art least one organic molecule M2 as defined above.

According to a preferred embodiment of the present invention, in step c an organic molecule M2 is used which is the same as organic molecule M1.

If M1 and M2 differ, preferably from 1 to 2 polymerizable units G1 in M1 are replaced by different polymerizable or non-polymerizable units G2 as defined above.

In cases where the second layer L2 is the last layer of the multilayer device deposited, it may not be necessary to use a monomer with polymerizable units and in this case M2 accordingly preferably does not comprise polymerizable units G2.

The liquid compositions C1 and C2 comprise the solvent compositions S1 respectively S2, which in turn contain the organic molecules M1 and M2. Besides these components, the liquid compositions C1 and C2 in accordance with the present invention may comprise additives and processing aids generally known to be useful in the deposition processes in steps a and c of the process in accordance with the present invention. The skilled person will select the appropriate additives and processing aids based on his professional knowledge and the circumstances of the specific application situation. Thus, no further details are necessary here.

In accordance with a preferred embodiment of the process in accordance with the present invention liquid composition C1 or liquid composition C2 or both liquid compositions may comprise at least one organic molecule M3, which may be the same or different in liquid composition C1 and liquid composition C2. Organic molecule M3, similar as organic molecules M1 and M2 has a molecular weight of at most 1000 Dalton, preferably of at most 700 Dalton.

The core of the organic molecule with M3 is chosen from benzene, pyridine, cyanurate and isocyanurate and the organic molecule M3 attached to its core bears $n^2$ polymerizable groups of formula (7)

$$- O_{c''} - (C(=O))_{d''} - O_{e''} - A^3 \qquad (7)$$

wherein n2 is an integer of from 2 to 4 and $A^3$ is vinyl or allyl and c", d" and e", independent of one another are 0 or 1. In accordance with a preferred embodiment $A^3$ is allyl and preferred organic molecules M3 are divinyl benzene, diallyl phthalate, triallylcyanurate and ztriallylcyanurate and mixtures thereof.

In accordance with the preferred embodiment either one or both liquid compositions comprise an organic

molecule M3 and in case said organic molecule M3 is contained in both liquid compositions, preferably that same organic molecule M3 is used.

Organic molecules M3 through their at least two polymerizable groups provide the opportunity to achieve a cross-linking in the course of the polymerization of organic molecules M1 and/or M2 which do not have more than one polymerizable group and thus will not yield a three-dimensional network with linked oligomer or polymer chains. As outlined hereinbefore, in certain cases the polymers without cross-linking may have a reduced solubility as required. If the reduction of solubility without linking of polymer or oligomer chains is not sufficient, the use of organic molecules M3 will provide the necessary cross-linking.

The concentration of organic molecules M3, if present, is usually within the range of from 0.1 to 20 mole%, preferably of from 0,5 to 10 mole% of the amount of organic molecule M1 and/or M2.

The process in accordance with the present invention is particularly suited for the manufacture of multilayer structures which form part of organic electronic devices, in particular organic light emitting diodes.

Due to the fact that the process uses solution based deposition methods, the amount of material needed for deposition is reduced and therefore economic advantages achieved over e.g. vapour deposition processes.

Due to the fact that the HOMO levels of the organic molecules M1 and M2 used for depositing the subsequent layers, as well as their LUMO levels, are very similar and in a preferred embodiment identical, certain advantages can be achieved compared to devices where there is a significant difference between either the HOMO levels, or the LUMO levels, or both, of the materials used for the subsequent layers. In principle, the subsequent layers obtained in accordance with that process of the present invention provide a homojunction between the two layers due to the very small difference in HOMO and LUMO levels of the respective layers and thus the advantages associated with homojunctions outlined hereinabove can be achieved with the process in accordance with the present invention.

The process in accordance with the present invention may be used for forming at least two layers of a multilayer device but it is immediately apparent to the skilled person that the process may be repeatedly carried out to obtain more than two consecutive layers of a multilayer device. The process is thus useful to obtain a multilayer structure wherein all the layers have been obtained by the process in accordance with the present invention or it may be used to obtain only part of the consecutive layers of the multilayer structure with one or more remaining layers being obtainable by other processes, e.g. vapour deposition technologies or the like.

In accordance with a preferred embodiment all the layers of the device are obtained in accordance with the process of the present invention.

## Claims

1. A process for the manufacture of a multilayer structure suitable for forming part of an organic electronic device having a cathode and an anode, comprising the steps of

   a. depositing a first layer L1 of the multilayer structure onto a substrate out of a liquid composition C1 comprising a solvent system S1 which solvent system S1 contains at least one organic molecule M1 having a molecular weight of at most 1,000 Dalton, wherein the substrate is a previously deposited layer L0 of the multilayer structure or is an element suitable for forming the cathode or the anode of the organic electronic device,
   b. thereafter chemically modifying the first layer L1 to reduce its solubility, as measured at room temperature (23°C) and atmospheric pressure (101.325 kPa), in a solvent system S2 which is identical to or different from solvent system S1, by at least 50 %, based on the solubility of the first layer L1 in the solvent system S2 before modification and
   c. thereafter depositing a second layer L2 of the multilayer structure onto the first layer L1 out of a liquid composition C2 comprising the solvent system S2, which solvent system comprises at least one organic molecule M2 having a molecular weight of at most 1,000 Dalton,
   wherein
   the organic molecule M1 contains $n^1$ polymerizable groups G1 with n1 being an integer of from 1 to 5,
   the organic molecule M2, which is identical to M1 or differs from M1 only in that in the organic molecule M2 1 to $n^1$ polymerizable groups G1 have been replaced by polymerizable or non-polymerizable groups G2 which differ from G1, and
   wherein the HOMO and LUMO levels of the organic molecule M1 are the same as, or differ by at most 0.2 eV from, respectively, the HOMO and LUMO levels of the organic molecule M2, as measured by cyclic voltammetry in solution.

2. The process in accordance with claim 1 wherein the polymerizable unit G1 is selected from the group consisting of vinyl ethers, halogenated vinyl ethers, siloxanes, oxetanes, cinnamates, chalcones, acrylates, methacrylates and

styryl groups.

3. The process in accordance with claim 1 wherein $n^1$ is an integer of from 1 to 5 and the polymerizable unit G1 is represented by general formula (1)

$$-(Z^1)_a - (Ph)_b - O_c - (C(=O))_d - D_e - A^1 \qquad (1)$$

wherein $A^1$ is selected from the group consisting of $C_2$-$C_{20}$ alkenyl groups, $C_2$-$C_{20}$ halogenated alkenyl groups, $C_4$-$C_{20}$ alkadienyl groups, halogenated $C_4$-$C_{20}$ alkadienyl groups, $C_4$-$C_{20}$ cycloalkenyl groups or $C_4$-$C_{20}$ alkylene bridged cycloalkenyl groups, Ph is p-phenylene,
$Z^1$ is selected from the group consisting of formulae (2) to (4)

$$C(R^1R^2)\text{-}(C(R^3R^4))_m \qquad (2)$$

(3) 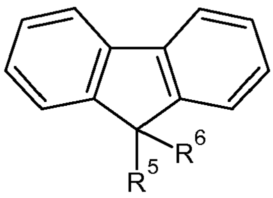 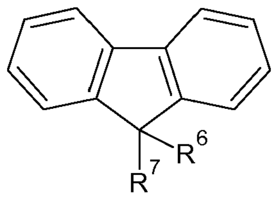 (4)

wherein the spacer $Z^1$ provides two bonding sites and
$R^1$ and $R^2$, independent of one another, each represent hydrogen, halogen, a $C_1$-$C_8$ alkyl group or an aryl group of from 5 to 30 carbon atoms,
$R^3$ and $R^4$, independent of one another, are hydrogen, a $C_1$ to $C_8$ alkyl group or an aryl group of from 5 to 30 carbon atoms and m is an integer of from 0 to 20,
$R^5$ represents hydrogen, $C_1$ to $C_8$-alkyl, or $C_5$ to $C_{30}$ aryl, and
$R^6$ and $R^7$, independently of one another, represent $C_1$-$C_8$ alkylene or $C_5$ to $C_{30}$ arylene
and a to e, independently of one another are each 0 or 1, and
in organic molecule M2, 1 to $n^1$ polymerizable units G1 have been replaced by polymerizable or non-polymerizable units G2, different from G1, and represented by general formulae (5)

$$-(Z^2)_{a'} - (Ph)_{b'} - O_{c'} - (C(=O))_{d'} - O_{e'} - A^2 \qquad (5)$$

wherein $A^2$ is chosen from hydrogen, halogen, $C_1$-$C_{20}$ alkyl groups, halogenated $C_1$-$C_{20}$ alkyl groups, $C_2$-$C_{20}$ alkenyl groups, $C_2$-$C_{20}$ halogenated alkenyl groups, $C_4$-$C_{20}$ alkadienyl groups, halogenated $C_4$-$C_{20}$ alkadienyl groups, $C_4$-$C_{20}$ cycloalkenyl groups or $C_4$-$C_{20}$ alkylene bridged cycloalkenyl groups, Ph is o-, m- or p-phenylene, $Z^2$ is selected from the group consisting of groups as defined above for $Z^1$ and a' to e', independently of one another are each 0 or 1.

4. The process in accordance with at least one of claims 1 to 3 wherein the solvent systems S1 and S2 are identical.

5. The process in accordance with at least one of claims 1 to 4 wherein the solubility in step b is reduced by at least 90 %.

6. The process in accordance with at least one of claims 1 to 5 wherein the HOMO levels of M1 and M2, and the LUMO levels of M1 and M2, are the same or differ by at most 0.1 eV.

7. The process in accordance with at least one of claims 3 to 6 wherein $n^1$ is 2 or 3.

8. The process in accordance with at least one of claims 3 to 7 wherein a is 1.

9. The process in accordance with any of claims 3 to 8 wherein at least one of b and c is 0.

10. The process in accordance with at least one of claims 3 to 9 wherein M2 is identical to M1.

**11.** The process in accordance with at least one of claims 1 to 10, wherein the liquid composition C1 or the liquid composition C2 or both liquid compositions C1 and C2 contain at least one organic molecule M3, which may be the same or different in liquid composition C1 and liquid composition C2, said organic molecule M3 having a molecular weight of at most 1,000 Dalton and having a core chosen from benzene, pyridine, cyanurate and isocyanurate, said core bearing $n^2$ reactive groups of formula (3)

$$- O_{c''} - (C(=O))_{d''} - O_{e''} - A^3 \qquad (7)$$

wherein $n^2$ is an integer of from 2 to 4 and $A^3$ is vinyl or allyl and c", d" and e", independent of one another are 0 or 1.

**12.** The process in accordance with claim 11 wherein $n^2$ is 2.

**13.** The process in accordance with claim 11 or 12 wherein $A^3$ is allyl.

**14.** The process in accordance with at least one of claims 11 to 13 wherein $A^3$ is selected from divinyl benzene, diallyl phthalate, triallylcyanurate and triallyl isocyanurate or mixtures thereof.

Europäisches Patentamt
European Patent Office
Office européen des brevets

# EUROPEAN SEARCH REPORT

Application Number
EP 12 18 6861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZACHARIAS PHILIPP ET AL: "New crosslinkable hole conductors for blue-phosphorescent organic light-emitting diodes", ANGEWANDTE CHEMIE. INTERNATIONAL EDITION, WILEY VCH VERLAG, WEINHEIM, vol. 46, no. 23, 1 January 2007 (2007-01-01), pages 4388-4392, XP009127589, ISSN: 1433-7851, DOI: 10.1002/ANIE.200605055 | 1-9, 11-14 | INV. H01L51/00 |
| Y | * page 4389, column 2, lines 7-9; figure Scheme 1; tables 1,2 * <br> * page 4390, column 1, lines 14-17 * <br> * page 4391, column 2, lines 28-42 * <br> ----- | 10 | |
| X | GEORGIOS LIAPTSIS ET AL: "Crosslinkable TAPC-Based Hole-Transport Materials for Solution-Processed Organic Light-Emitting Diodes with Reduced Efficiency Roll-Off", ADVANCED FUNCTIONAL MATERIALS, vol. 23, no. 3, 28 August 2012 (2012-08-28), pages 359-365, XP055055176, ISSN: 1616-301X, DOI: 10.1002/adfm.201201197 <br> * page 365, column 1, lines 34-47; figure Scheme 1; tables 1,2 * <br> * page 363, column 1, line 19 - column 2, line 7 * <br> ----- <br> -/-- | 1 | TECHNICAL FIELDS SEARCHED (IPC) <br> H01L |

The present search report has been drawn up for all claims

1

| Place of search | Date of completion of the search | Examiner |
|---|---|---|
| The Hague | 6 March 2013 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 12 18 6861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CHAO CAI ET AL: "Efficient Low-Driving-Voltage Blue Phosphorescent Homojunction Organic Light-Emitting Devices", JAPANESE JOURNAL OF APPLIED PHYSICS, THE JAPAN SOCIETY OF APPLIED PHYSICS, JAPAN SOCIETY OF APPLIED PHYSICS, TOKYO; JP, vol. 50, no. 4 - PT1, 1 April 2011 (2011-04-01), pages 40204-1, XP001564325, ISSN: 0021-4922, DOI: 10.1143/JJAP.50.040204 [retrieved on 2011-04-05] * figure 1 * ----- | 10 | |
| A | US 2010/323464 A1 (CHEON KWANG-OHK [US] ET AL) 23 December 2010 (2010-12-23) * paragraphs [0056] - [0070] * ----- | 1-14 | |
| A | CHENGMEI ZHONG ET AL: "Materials and Devices toward Fully Solution Processable Organic Light-Emitting Diodes", CHEMISTRY OF MATERIALS, AMERICAN CHEMICAL SOCIETY, WASHINGTON, DC, US, vol. 23, no. 3, 8 February 2011 (2011-02-08), pages 326-340, XP002683467, ISSN: 1520-5002, DOI: 10.1021/CM101937P [retrieved on 2010-10-21] * page 327, column 2, line 3 - page 328, column 2, line 11; figure 3 * ----- | 1-14 | TECHNICAL FIELDS SEARCHED (IPC) |

-/--

The present search report has been drawn up for all claims

1

| Place of search | Date of completion of the search | Examiner |
|---|---|---|
| The Hague | 6 March 2013 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 12 18 6861

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YEN-JU CHENG ET AL: "Exciplex Electroluminescence Induced by Cross-Linked Hole-Transporting Materials for White Light Polymer Light-Emitting Diodes", MACROMOLECULES, vol. 44, no. 15, 9 August 2011 (2011-08-09), pages 5968-5976, XP055055195, ISSN: 0024-9297, DOI: 10.1021/ma2006969 * page 5971, column 2, line 3 - page 5973, column 2, line 16; figure Scheme 1 * * page 5974, column 1, lines 36-58 * ----- | 1-14 | |
| A | CHI-YEN LIN ET AL: "A thermally cured 9,9-diarylfluorene-based triaryldiamine polymer displaying high hole mobility and remarkable ambient stability", JOURNAL OF MATERIALS CHEMISTRY, vol. 19, no. 22, 1 January 2009 (2009-01-01), pages 3618-3623, XP055055226, ISSN: 0959-9428, DOI: 10.1039/b900977a * page 3622, column 2, line 41 - page 3623, column 1, line 6; figure Scheme 1 * ----- | 1-14 | TECHNICAL FIELDS SEARCHED (IPC) |
| A | WO 2011/119162 A1 (UNIVERSAL DISPLAY CORP [US]; XIA CHUANJUN [US]; CHEON KWANG OHK [US]) 29 September 2011 (2011-09-29) * paragraph [0133] * ----- | 1-14 | |

The present search report has been drawn up for all claims

1

| Place of search | Date of completion of the search | Examiner |
|---|---|---|
| The Hague | 6 March 2013 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 12 18 6861

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2013

| Patent document cited in search report | Publication date | Patent family member(s) | Publication date |
|---|---|---|---|
| US 2010323464 A1 | 23-12-2010 | CN 102460759 A | 16-05-2012 |
| | | JP 2012531012 A | 06-12-2012 |
| | | KR 20120037409 A | 19-04-2012 |
| | | TW 201107435 A | 01-03-2011 |
| | | US 2010323464 A1 | 23-12-2010 |
| | | US 2012270349 A1 | 25-10-2012 |
| | | WO 2010147818 A1 | 23-12-2010 |
| WO 2011119162 A1 | 29-09-2011 | CN 102823013 A | 12-12-2012 |
| | | EP 2550690 A1 | 30-01-2013 |
| | | TW 201202196 A | 16-01-2012 |
| | | WO 2011119162 A1 | 29-09-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7911129 B


### Non-patent literature cited in the description


- **CAI et al.** *Organic Electronics,* 2011, vol. 12, 843
- **HARADA et al.** *Phys. Rev. Lett.,* 2005, vol. 94, 036601
- **HARADA et al.** *Phys. Review,* 2008, vol. 77, 195212
- **ZUNIGA et al.** *Chem. Mater.,* 2011, vol. 23, 658-681
- **LEUNG et al.** *Proc. of SPIE,* 2007, vol. 6828, 68280D
- **HO et al.** *Appl. Phys. Lett.,* 2004, vol. 85, 4576
- **POMMEREHENE et al.** *Adv. Mater.,* 1995, vol. 7 (6), 551-554
- **ZUNIGA.** *Chem. Mater.,* 2011, vol. 23, 658
- **ZUNIGA et al.** *Chem. Mater.,* 2011, vol. 23, 658